# EUROPEAN PATENT APPLICATION

(11) **EP 4 230 945 A1**
(43) Date of publication of application: **23.08.2023**
(21) Application number: 23156081.4
(22) Date of filing: 10.02.2023
(51) Int. Cl.: F28D 15/02, F28D 15/04, H01F 7/02

(54) **LOOP-TYPE HEAT PIPE**

(30) Priority: 18.02.2022 JP 2022023454
(71) Applicant: SHINKO ELECTRIC INDUSTRIES CO., LTD., Nagano-shi, Nagano 381-2287 (JP)
(72) Inventor: MACHIDA, Yoshihiro, Nagano-shi, 381-2287 (JP)
(74) Representative: Zimmermann & Partner Patentanwälte mbB

(57) **Abstract**

A loop-type heat pipe includes a loop-type heat pipe main body (10) including a loop-shaped flow path (15) in which a working fluid is enclosed, a heat dissipation plate (30) thermally connected to the loop-type heat pipe main body (10), a magnetic member (50) provided on a surface of at least one of the loop-type heat pipe main body (10) and the heat dissipation plate (30), and a magnet (60) provided for the other of the loop-type heat pipe main body (10) and the heat dissipation plate (30) and provided facing the magnetic member (50).

## Description

### TECHNICAL FIELD

The present invention relates to a loop-type heat pipe.

### BACKGROUND ART

In the related art, as a device configured to cool a heat-generating component of a semiconductor device (for example, a CPU or the like) mounted on an electronic device, suggested is a heat pipe configured to transport heat by using a phase change of a working fluid (for example, refer to JP6291000B and JP6400240B).

As an example of the heat pipe, known is a loop-type heat pipe including an evaporator configured to vaporize a working fluid by heat of a heat-generating component and a condenser configured to cool and condense the vaporized working fluid, in which the evaporator and the condenser are connected to each other by a liquid pipe and a vapor pipe configured to form a loop-shaped flow path. In the loop-type heat pipe, the working fluid flows in one direction along the loop-shaped flow path.

### SUMMARY OF INVENTION

In the meantime, in the above-described loop-type heat pipe, improvement in heat dissipation property is desired, and there is still room for improvement in this respect.

Certain embodiment provides a loop-type heat pipe.

The loop-type heat pipe comprises a loop-type heat pipe main body including a loop-shaped flow path in which a working fluid is enclosed, a heat dissipation plate thermally connected to the loop-type heat pipe main body, a magnetic member provided on a surface of at least one of the loop-type heat pipe main body and the heat dissipation plate, and a magnet provided for the other of the loop-type heat pipe main body and the heat dissipation plate and provided facing the magnetic member.

According to one aspect of the present invention, it is possible to obtain an effect capable of improving a heat dissipation property.

### BRIEF DESCRIPTION OF DRAWINGS

In the following, embodiments are described with reference to the drawings without being limited thereto.
FIG. 1 is a schematic cross-sectional view (a cross-sectional view taken along a line 1-1 in FIG. 2) showing a loop-type heat pipe of one embodiment.
FIG. 2 is a schematic plan view showing the loop-type heat pipe of one embodiment.
FIG. 3 is a schematic cross-sectional view showing the loop-type heat pipe of one embodiment.
FIG. 4 is a schematic cross-sectional view showing a loop-type heat pipe of a modified embodiment.
FIG. 5 is a schematic cross-sectional view showing a loop-type heat pipe of a modified embodiment.
FIG. 6 is a schematic cross-sectional view showing a loop-type heat pipe of a modified embodiment.
FIG. 7 is a schematic cross-sectional view showing a loop-type heat pipe of a modified embodiment.
FIG. 8 is a schematic cross-sectional view showing a loop-type heat pipe of a modified embodiment.
FIG. 9 is a schematic cross-sectional view showing a loop-type heat pipe of a modified embodiment.
FIG. 10 is a schematic cross-sectional view showing a loop-type heat pipe of a modified embodiment.
FIG. 11 is a schematic plan view showing a loop-type heat pipe of a modified embodiment.

### DESCRIPTION OF EMBODIMENTS

Hereinafter, one embodiment will be described with reference to the accompanying drawings.

Note that, for convenience sake, in the accompanying drawings, a characteristic part may be enlarged so as to easily understand the feature, and the dimension ratios of the respective constitutional elements may be different in the respective drawings. In addition, in the cross-sectional views, hatching of some members is shown in a satin form and hatching of some members is omitted, so as to easily understand a sectional structure of each member. In the respective drawings, an X-axis, a Y-axis, and a Z-axis orthogonal to each other are shown. In descriptions below, for convenience sake, a direction extending along the X-axis is referred to as 'X-axis direction', a direction extending along the Y-axis is referred to as 'Y-axis direction', and a direction extending along the Z-axis is referred to as 'Z-axis direction'. Note that, in the present specification, 'in a top view' means seeing a target object in the Z-axis direction, and 'planar shape' means a shape of a target object as seen in the Z-axis direction.

### (Overall Configuration of Loop-Type Heat Pipe LH1)

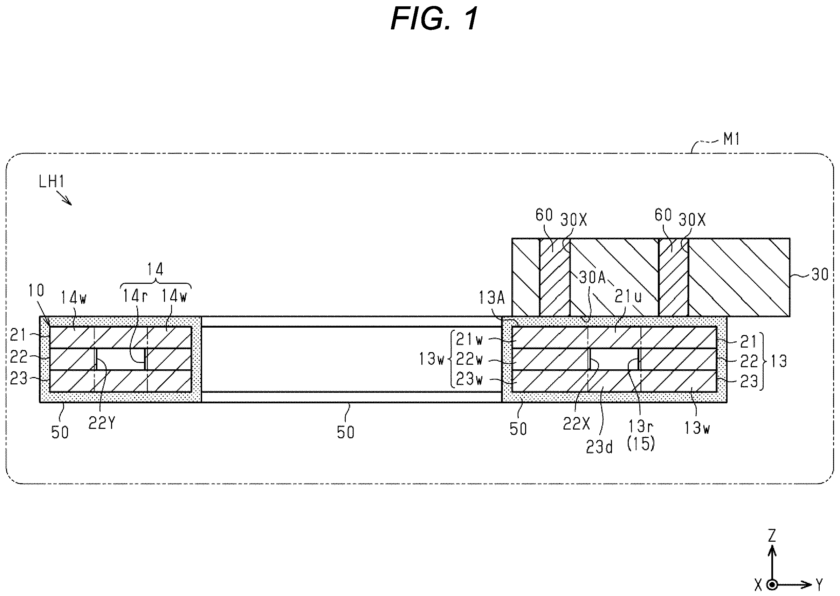

A loop-type heat pipe LH1 shown in FIG. 1 is accommodated in a mobile electronic device M1 such as a smart phone and a tablet terminal. The loop-type heat pipe LH1 includes a loop-type heat pipe main body 10, a heat dissipation plate 30 thermally connected to the loop-type heat pipe main body 10, a magnetic film 50 provided on a surface of the loop-type heat pipe main body 10, and a magnet 60 provided in the heat dissipation plate 30.

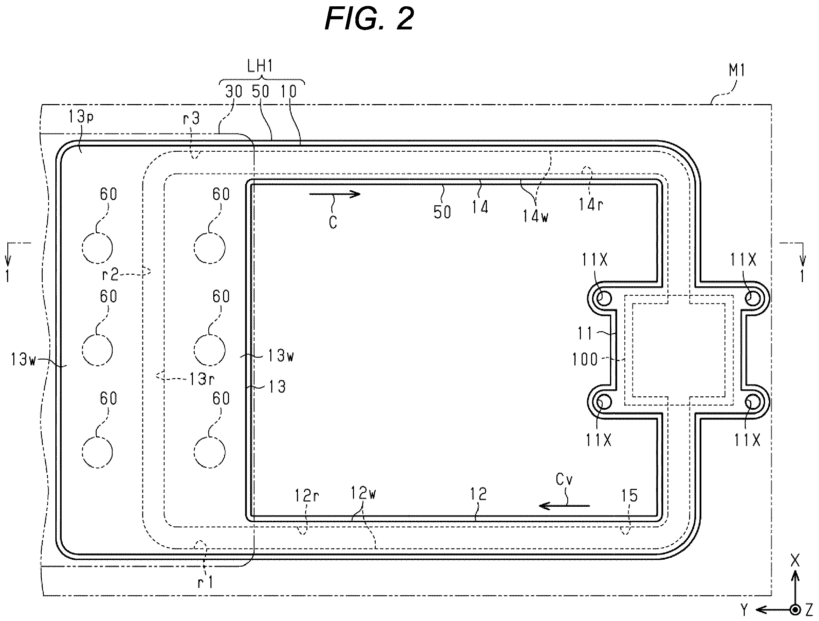

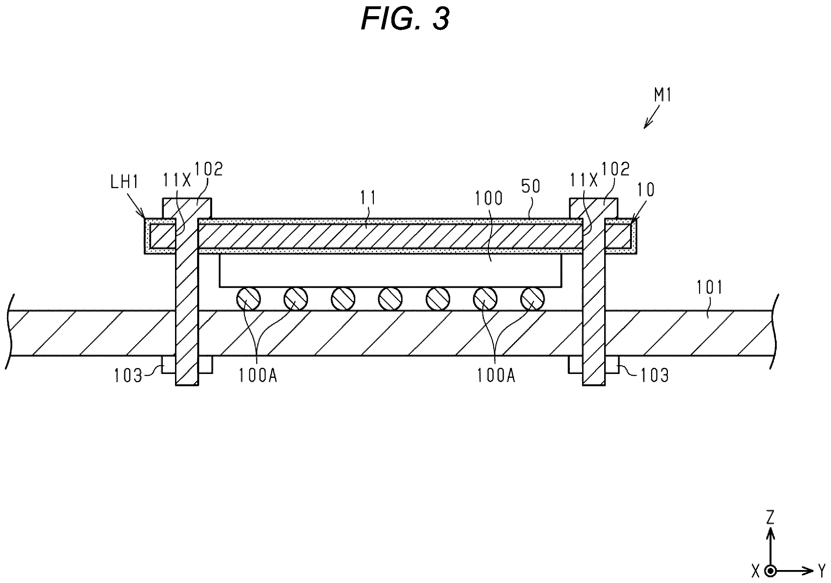

As shown in FIGS. 2 and 3, a heat-generating component 100 is thermally connected to the loop-type heat pipe LH1. As shown in FIG. 3, the heat-generating component 100 is mounted on a wiring substrate 101. The heat-generating component 100 and the wiring substrate 101 are accommodated in the electronic device M1. Here, the electronic device M1 is, for example, an electronic device on which the heat-generating component 100 and a device configured to cool the heat-generating component 100 are mounted. As the device configured to cool the heat-generating component 100, known is a heat pipe configured to transport heat by using a phase change of a working fluid. As an example of the heat pipe, the loop-type heat pipe LH1 may be exemplified.

### (Configuration of Loop-Type Heat Pipe Main Body 10)

As shown in FIG. 2, the loop-type heat pipe main body 10 includes an evaporator 11, a vapor pipe 12, a condenser 13 and a liquid pipe 14.

The evaporator 11 and the condenser 13 are connected by the vapor pipe 12 and the liquid pipe 14. The evaporator 11 has a function of vaporizing a working fluid C to generate vapor Cv. The vapor Cv generated in the evaporator 11 is sent to the condenser 13 via the vapor pipe 12. The condenser 13 has a function of condensing the vapor Cv of the working fluid C. The condensed working fluid C is sent to the evaporator 11 via the liquid pipe 14. The vapor pipe 12 and the liquid pipe 14 are configured to form a loop-shaped flow path 15 through which the working fluid C or the vapor Cv is caused to flow. In the flow path 15, the working fluid C is enclosed.

The vapor pipe 12 is formed, for example, by an elongated pipe body. The liquid pipe 14 is formed, for example, by an elongated pipe body. In the present embodiment, the vapor pipe 12 and the liquid pipe 14 are the same in dimension (i.e., length) in a length direction, for example. Note that, the length of the vapor pipe 12 and the length of the liquid pipe 14 may be different from each other. For example, the length of the vapor pipe 12 may be shorter than the length of the liquid pipe 14. Here, in the present specification, the 'length direction' of the evaporator 11, the vapor pipe 12, the condenser 13 and the liquid pipe 14 is a direction that coincides with a direction (refer to an arrow in the drawing) in which the working fluid C or vapor Cv flows in each member. In addition, in the present specification, the 'same' includes not only a case in which comparison targets are exactly the same but also a case in which there is a slight difference between the comparison targets due to influences of dimensional tolerances and the like.

As shown in FIG. 3, the evaporator 11 is fixed in close contact with the heat-generating component 100. The evaporator 11 is fixed to an upper surface of the heat-generating component 100, for example. The evaporator 11 has, for example, a plurality of (four, in the present embodiment) attaching holes 11X. Each attaching hole 11X is formed to penetrate through the evaporator 11 in a thickness direction (here, Z-axis direction). The evaporator 11 is fixed to the wiring substrate 101 by, for example, a screw 102 inserted in each attaching hole 11X and a nut 103 screwed onto the screw 102. The heat-generating component 100 is mounted on the wiring substrate 101. The heat-generating component 100 is mounted on the wiring substrate 101 by bumps 100A, for example. A lower surface of the evaporator 11 is in close contact with the upper surface of the heat-generating component 100. As the heat-generating component 100, for example, a semiconductor device such as a CPU (Central Processing Unit) chip or a GPU (Graphics Processing Unit) chip may be used.

As shown in FIG. 2, the working fluid C in the evaporator 11 is vaporized by heat generated by the heat-generating component 100. Thereby, the vapor Cv is generated. The vapor Cv generated in the evaporator 11 is guided to the condenser 13 via the vapor pipe 12.

The vapor pipe 12 has a pair of pipe walls 12w provided on both sides in a width direction orthogonal to the length direction of the evaporator 12, in a top view, and a flow path 12r provided between the pair of pipe walls 12w, for example. The flow path 12r is formed to communicate with an internal space of the evaporator 11. The flow path 12r is a part of the loop-shaped flow path 15.

The condenser 13 has a heat dissipation plate 13p whose area is increased for heat dissipation, and a flow path 13r provided in the heat dissipation plate 13p, for example. The flow path 13r has a flow path r1 formed to communicate with the flow path 12r and extending in the Y-axis direction, a flow path r2 bent from the flow path r1 and extending in the X-axis direction, and a flow path r3 bent from the flow path r2 and extending in the Y-axis direction. The flow path 13r (flow paths r1 to r3) is a part of the loop-shaped flow path 15. The condenser 13 has pipe walls 13w provided on both sides in a direction orthogonal to a length direction of the flow path 13r, i.e., the flow paths r1 to r3, in the top view. The vapor Cv guided via the vapor pipe 12 is condensed in the condenser 13. The working fluid C condensed in the condenser 13 is guided to the evaporator 11 through the liquid pipe 14.

The liquid pipe 14 has a pair of pipe walls 14w provided on both sides in the width direction orthogonal to the length direction of the liquid pipe 14, in the top view, and a flow path 14r provided between the pair of pipe walls 14w, for example. The flow path 14r is formed to communicate with the flow path 13r (specifically, the flow path r3) of the condenser 13 and the internal space of the evaporator 11. The flow path 14r is a part of the loop-shaped flow path 15.

In the loop-type heat pipe LH1, the heat generated by the heat-generating component 100 is transferred to the condenser 13 and dissipated in the condenser 13. Thereby, since the heat-generating component is 100 is cooled, the temperature rise of the heat-generating component 100 is suppressed.

Here, as the working fluid C, a fluid having a high vapor pressure and a high latent heat of vaporization is preferably used. By using such working fluid C, it is possible to effectively cool the heat-generating component 100 by the latent heat of vaporization. As the working fluid C, ammonia, water, freon, alcohol, acetone or the like can be used, for example.

### (Specific Structure of Condenser 13)

FIG. 1 shows a cross section of the loop-type heat pipe LH1 taken along a line 1-1 of FIG. 2. This cross section is a plane orthogonal to the direction in which the working fluid flows in the condenser 13 and the liquid pipe 14.

As shown in FIG. 1, the condenser 13 has a structure in which three metal layers 21, 22 and 23, for example, are stacked. In other words, the condenser 13 has a structure in which the metal 22, which is an inner metal layer, is stacked between the metal layers 21 and 23, which are a pair of outer metal layers. The inner metal layer of the condenser 13 of the present embodiment is configured by only one metal layer 22.

Each of the metal layers 21 to 23 is a copper (Cu) layer having excellent thermal conductivity. The plurality of metal layers 21 to 23 are directly bonded to each other by solid-phase bonding such as diffusion bonding, pressure welding, friction pressure welding and ultrasonic bonding. Note that, in FIG. 1, the metal layers 21 to 23 are identified by solid lines for easy understanding. For example, when the metal layers 21 to 23 are integrated by diffusion bonding, interfaces of the respective metal layers 21 to 23 may be lost, and therefore, boundaries may not be clear. As used herein, the solid-phase bonding is a method of heating and softening bonding target objects in a solid-phase (solid) state without melting the same, and then further heating, plastically deforming and bonding the bonding target objects. Note that, the metal layers 21 to 23 are not limited to the copper layers and may also be formed of stainless steel, aluminum, magnesium alloy or the like. In addition, for some of the stacked metal layers 21 to 23, a material different from the other metal layers may be used. A thickness of each of the metal layers 21 to 23 may be set to about 50 µm to 200 µm, for example. Note that, some of the metal layers 21 to 23 may be formed to have a thickness different from those of the other metal layers, and all the metal layers may be formed to have thicknesses different from each other.

The condenser 13 is configured by the metal layers 21 to 23 stacked in the Z-axis direction, and has the flow path 13r and the pair of pipe walls 13w provided on both sides of the flow path 13r in the Y-axis direction.

The metal layer 22 is stacked between the metal layer 21 and the metal layer 23. An upper surface of the metal layer 22 is bonded to the metal layer 21. A lower surface of the metal layer 22 is bonded to the metal layer 23. The metal layer 22 has a through-hole 22X penetrating through the metal layer 22 in the thickness direction, and a pair of pipe walls 22w provided on both sides of the through-hole 22X in the Y-axis direction. The through-hole 22X constitutes the flow path 13r.

The metal layer 21 is stacked on the upper surface of the metal layer 22. The metal layer 21 has pipe walls 21w provided at positions overlapping the pipe walls 22w in the top view, and an upper wall 21u provided at a position overlapping the flow path 13r in the top view. A lower surface of the pipe wall 21w is bonded to an upper surface of the pipe wall 22w. The upper wall 21u is provided between the pair of pipe walls 21w. A lower surface of the upper wall 21u is exposed to the flow path 13r. In other words, the upper wall 21u constitutes the flow path 13r.

The metal layer 23 is stacked on the lower surface of the metal layer 22. The metal layer 23 has pipe walls 23w provided at positions overlapping the pipe walls 22w in the top view, and a lower wall 23d provided at a position overlapping the flow path 13r in the top view. An upper surface of the pipe wall 23w is bonded to a lower surface of the pipe wall 22w. The lower wall 23d is provided between the pair of pipe walls 23w. An upper surface of the lower wall 23d is exposed to the flow path 13r. In other words, the lower wall 23d constitutes the flow path 13r.

The flow path 13r is configured by the through-hole 22X of the metal layer 22. The flow path 13r is formed by a space surrounded by an inner wall surface of the through-hole 22X, the lower surface of the upper wall 21u, and the upper surface of the lower wall 23d.

Each pipe wall 13w is configured by, for example, the pipe wall 21w of the metal layer 21, the pipe wall 22w of the metal layer 22, and the pipe wall 23w of the metal layer 23.

The condenser 13 has a first facing surface 13A facing the heat dissipation plate 30. The first facing surface 13 A is configured by, for example, the upper surface of the metal layer 21 in the condenser 13. Note that, in the present specification, 'facing' indicates that surfaces or members are in front of each other, and includes not only a case in which they are completely in front of each other, but also a case in which they are partially in front of each other. Also, in the present specification, 'facing' includes both a case in which a member different from two parts is interposed between the two parts and a case in which no member is interposed between the two parts.

### (Configuration of Vapor pipe 12)

The vapor pipe 12 shown in FIG. 2 is formed by the three stacked metal layers 21 to 23 (refer to FIG. 1), similarly to the condenser 13. For example, in the vapor pipe 12, the flow path 12r is formed by forming a through-hole penetrating through the metal layer 22, which is an inner metal layer, in the thickness direction.

### (Configuration of Liquid Pipe 14)

As shown in FIG. 1, the liquid pipe 14 is formed by the three stacked metal layers 21 to 23, similarly to the condenser 13. In the liquid pipe 14, the flow path 14r is formed by forming a through-hole 22Y penetrating through the metal layer 22, which is an inner metal layer, in the thickness direction. The liquid pipe 14 has the pair of pipe walls 14w provided on both sides of the flow path 14r. Each pipe wall 14w is not formed with a hole or a groove. The liquid pipe 14 may have a porous body, for example. The porous body is configured to have, for example, first bottomed holes concave from the upper surface of the metal layer 22, which is an inner metal layer, second bottomed holes concave from the lower surface of the metal layer 22, and pores formed by causing the first bottomed holes and the second bottomed holes to partially communicate with each other. The porous body is configured to guide the working fluid C condensed in the condenser 13 to the evaporator (refer to FIG. 2) by a capillary force generated in the porous body 20, for example. In addition, although not shown, the liquid pipe 14 is provided with an injection port for injecting the working fluid C (refer to FIG. 2). However, the injection port is closed by a sealing member, so that an inside of the loop-type heat pipe main body 10 is kept airtight.

### (Configuration of Evaporator 11)

The evaporator 11 shown in FIG. 2 is formed by the three stacked metal layers 21 to 23 (refer to FIG. 1), similarly to the condenser 13. The evaporator 11 may have a porous body, similarly to the liquid pipe 14, for example. For example, in the evaporator 11, a porous body provided in the evaporator 11 is formed in a comb-teeth shape. In the evaporator 11, a region in which the porous body is not provided has a space.

In this way, the loop-type heat pipe main body 10 is configured by the three stacked metal layers 21 to 23 (refer to FIG. 1). Note that, the number of the stacked metal layers is not limited to three layers, and may be four or more layers.

### (Configuration of Magnetic Film 50)

As shown in FIG. 1, the magnetic film 50 is provided on a surface of the loop-type heat pipe main body 10. The magnetic film 50 is provided on a surface of the condenser 13, for example. The magnetic film 50 is formed to cover an entire surface of the condenser 13, for example. The magnetic film 50 is formed to cover an entire upper surface of the condenser 13, i.e., an entire surface of the first facing surface 13A, for example. The magnetic film 50 is formed to cover an entire side surface of the condenser 13, i.e., entire outer surfaces of the pipe walls 21w, 22w and 23w, for example. The magnetic film 50 is formed to cover an entire lower surface of the condenser 13, for example. The magnetic film 50 is formed to cover an entire surface of the loop-type heat pipe main body 10, for example. The magnetic film 50 is formed to cover an entire upper surface, an entire side surface and an entire lower surface of the loop-type heat pipe main body 10, for example.

As a material of the magnetic film 50, a magnetic material may be used. As the material of the magnetic film 50, a ferromagnetic material exhibiting ferromagnetism may be used. As the material of the magnetic film 50, nickel (Ni), iron (Fe), cobalt (Co) or alloys thereof may be used. As the material of the magnetic film 50 of the present embodiment, a nickel alloy containing nickel and phosphorous (P), for example, a nickel-phosphorous alloy may be used. The magnetic film 50 is a plating film formed by, for example, an electroless plating method or an electrolytic plating method. The magnetic film 50 is a plating film made of a ferromagnetic material, for example. In the present embodiment, the magnetic film 50 is a nickel plating film. Such a nickel plating film has a rust-preventing function of preventing rust on the surface of the loop-type heat pipe main body 10, i.e., surfaces of the metal layer 21 to 23 (refer to FIG. 1) A thickness of the magnetic film 50 may be set to about 50 µm to 100 µm, for example. The magnetic film 50 of the present embodiment is formed by forming an electrolytic plating film on the surface of the loop-type heat pipe main body 10 by an electrolytic plating method, and then forming an electroless plating film on the electrolytic plating film by an electroless plating method.

### (Configuration of Heat Dissipation Plate 30)

As shown in FIG. 1, the heat dissipation plate 30 is fixed to the loop-type heat pipe main body 10. The heat dissipation plate 30 is fixed to the condenser 13 of the loop-type heat pipe main body 10, for example. The heat dissipation plate 30 is fixed to an outer surface of the condenser 13 in a state in which the magnetic film 50 is interposed between the outer surface of the condenser 13 and the heat dissipation plate 30, for example. The heat dissipation plate 30 is fixed to the outer surface of the condenser 13 by a magnetic attraction force (adsorption force) generated between the magnet 60 and the magnetic film 50, for example. The heat dissipation plate 30 is provided at a position overlapping the condenser 13, in the top view, for example. The heat dissipation plate 30 is formed in a flat plate shape, for example. The heat dissipation plate 30 has a rectangular shape in the top view, for example. A planar shape of the heat dissipation plate 30 is formed to be larger than a planar shape of the condenser 13, for example. For this reason, the heat dissipation plate 30 is provided so that a part thereof overlaps the condenser 13 in the top view. The heat dissipation plate 30 is thermally connected to the first facing surface 13A of the condenser 13, for example. The heat dissipation plate 30 is thermally connected to the condenser 13 via the magnetic film 50, for example. The heat dissipation plate 30 is also referred to as a heat spreader. The heat dissipation plate 30 is thermally connected to the condenser 13, so that it has, for example, a function of dispersing a density of heat from the condenser 13.

As a material of the heat dissipation plate 30, a material having favorable thermal conductivity may be used, for example. As the heat dissipation plate 30, a substrate made of copper (Cu), silver (Ag), aluminum (Al) or an alloy thereof can be used. As the heat dissipation plate 30, for example, a substrate made of ceramics such as alumina or aluminum nitride, or an insulating material or semiconductor material having high thermal conductivity such as silicon can also be used. Note that, a thickness of the heat dissipation plate 30 in the Z-axis direction may be set to about 500 µm to 1000 µm, for example. The thickness of the heat dissipation plate 30 is formed thicker than an overall thickness of the loop-type heat pipe main body 10, for example.

The heat dissipation plate 30 has a second facing surface 30A (here, lower surface) facing the first facing surface 13A of the condenser 13. The second facing surface 30A faces the first facing surface 13A in the Z-axis direction. The second facing surface 30A is thermally connected to the first facing surface 13A, for example. The second facing surface 30A is in direct contact with the magnetic film 50 of a part that covers the first facing surface 13A, for example. The second facing surface 30A is thermally connected to the first facing surface 13A via the magnetic film 50, for example. That is, the second facing surface 30A is connected to the first facing surface 13A via the magnetic film 50, so that the heat dissipation plate 30 of the present embodiment is thermally connected to the loop-type heat pipe main body 10.

### (Configuration of Magnet 60)

The magnet 60 is provided in the heat dissipation plate 30. The heat dissipation plate 30 is provided with, for example, a plurality of magnets 60. Each of the magnets 60 is embedded in the heat dissipation plate 30, for example. Each of the magnets 60 is provided to face the magnetic film 50 that covers the first facing surface 13A of the condenser 13, for example. Each of the magnets 60 is provided at a position overlapping the condenser 13, in the top view, for example. Each of the magnets 60 of the present embodiment is provided at a position overlapping the pipe wall 13w of the condenser 13 in the top view.

Each of the magnets 60 is provided to penetrate through the heat dissipation plate 30 in the thickness direction, for example. For example, the heat dissipation plate 30 is provided with a plurality of through-holes 30X penetrating through the heat dissipation plate 30 in the thickness direction. Each of the magnets 60 is accommodated in each through-hole 30X, for example. A side surface of each of the magnets 60 is in close contact with an inner surface of each through-hole 30X, for example. The side surface of each of the magnets 60 is in close contact with the inner surface of each through-hole 30X over an entire circumference of the magnet 60 in a circumferential direction, for example. Note that, the side surface of each of the magnets 60 and the inner surface of each through-hole 30X may be in direct contact with each other or may be in contact with each other via an adhesive member or the like. An upper surface of each of the magnets 60 is exposed from the upper surface of the heat dissipation plate 30, for example. The upper surface of each of the magnets 60 is formed flush with the upper surface of the heat dissipation plate 30, for example. A lower surface of each of the magnets 60 is exposed, for example, from the second facing surface 30A. The lower surface of each of the magnets 60 is formed flush with the second facing surface 30A, for example. The lower surface of each of the magnets 50 is in direct contact with the magnetic film 50, for example. The lower surface of each of the magnets 60 is in direct contact with the magnetic film 50 of a part that covers the first facing surface 13A of the condenser 13, for example.

A planar shape of each of the magnets 60 can be formed to have arbitrary shape and size. As shown in FIG. 2, the planar shape of each of the magnets 60 of the present embodiment is formed in a circular shape. That is, each of the magnets 60 of the present embodiment is formed in a cylindrical shape. The plurality of magnets 60 are provided side by side along one direction (here, X-axis direction) of a plane direction orthogonal to the thickness direction (here, Z-axis direction) of the heat dissipation plate 30, for example. The plurality of magnets 60 are provided spaced apart from each other in the X-axis direction, for example. In the heat dissipation plate 30 of the present embodiment, on each of both sides of the flow path 13r (specifically, flow path r2) in the Y-axis direction, three magnets 60 are provided spaced apart from each other in the X-axis direction. For example, the magnet 60 provided at a position overlapping, in the top view, the pipe wall 13w on one side and the magnet 60 provided at a position overlapping, in the top view, the pipe wall 13w on the other side are provided at the same positions in the X-axis direction. Note that, the magnet 60 provided at a position overlapping, in the top view, the pipe wall 13w on one side and the magnet 60 provided at a position overlapping, in the top view, the pipe wall 13w on the other side may be provided at positions different from each other in the X-axis direction. In addition, the magnet 60 may be provided at a position overlapping the flow path 13r in the top view.

As the magnet 60, for example, a samarium cobalt magnet, an alnico magnet, or the like can be used. As the magnet 50, for example, it is preferably to use a magnet with relatively small demagnetization (reduction in magnetic force) due to heat, i.e., relatively small thermal demagnetization. The magnet 60 of the present embodiment is a samarium cobalt magnet with small thermal demagnetization.

As shown in Fig. 1, when the magnet 60 and the magnetic film 50 come close to each other, a magnetic attraction force (adsorption force) with which the magnet 60 and the magnetic film 50 try to adsorb each other is generated between the magnet 60 and the magnetic film 50. By the magnetic attraction force, the magnet 60 and the magnetic film 50 are adsorbed to each other. In the loop-type heat pipe LH1 of the present embodiment, in a state in which the lower surface of the magnet 60 and the upper surface of the magnetic film 50 are in direct contact with each other, the magnet 60 and the magnetic film 50 are magnetically adsorbed to each other. Thereby, the heat dissipation plate 30 is fixed on the condenser 13 of the loop-type heat pipe main body 10 via the magnetic film 50. That is, the heat dissipation plate 30 is fixed on the condenser 13 by the attraction force (adsorption force) generated between the magnet 60 and the magnetic film 50. In other words, the type and thickness of the magnetic film 50 and the type, number, size, and the like of the magnet 60 are set so that the heat dissipation plate 30 can be fixed on the condenser 13. Here, in the loop-type heat pipe LH1 of the present embodiment, the first facing surface 13A of the condenser 13 and the second facing surface 30A of the heat dissipation plate 30 are connected via the magnetic film 50, so that the condenser 13 and the heat dissipation plate 30 are thermally connected to each other. Thereby, a path through which heat is conducted from the condenser 13 to the heat dissipation plate 30 via the magnetic film 50 is formed. Therefore, the heat in the condenser 13 can be efficiently dissipated by the heat dissipation plate 30. For this reason, the heat-generating component (refer to FIG. 3) can be efficiently cooled. Thereby, it is possible to favorably suppress the heat generated by the heat-generating component 100 from exceeding the heat tolerance of the heat-generating component 100.

Next, the effects of the present embodiment are described.
(1) The heat dissipation plate 30 is thermally connected to the condenser 13. According to this configuration, a path through which heat is conducted from the condenser 13 to the heat dissipation plate 30 is formed. Thereby, the heat in the condenser 13 can be efficiently dissipated by the heat dissipation plate 30. For this reason, the heat dissipation property in the loop-type heat pipe main body 10 and the heat dissipation plate 30, i.e., the heat dissipation property in the loop-type heat pipe LH1 can be improved. As a result, the heat-generating component 100 can be efficiently cooled.
(2) The magnetic film 50 is provided on the surface of the condenser 13 and the magnet 60 facing the magnetic film 50 is provided in the heat dissipation plate 30. According to this configuration, the heat dissipation plate 30 can be fixed on the condenser 13 of the loop-type heat pipe main body 10 by the magnetic attraction force (adsorption force) generated between the magnet 60 and the magnetic film 50. For this reason, the heat dissipation plate 30 can be fixed on the condenser 13 without using a screw, an adhesive or the like. Here, in a case of a fixing method in which a screw is used, when the torque required for fastening the screw increases, there is a concern that the condenser 13 may be deformed or distorted. In addition, in a case of a fixing method in which an adhesive is used, an adhesive layer is interposed between the condenser 13 and the heat dissipation plate 30. However, in general, since the adhesive layer has low thermal conductivity, there is a problem that the thermal conductivity from the condenser 13 to the heat dissipation plate 30 is lowered, as compared to a case in which the adhesive layer is not provided. On the other hand, in the loop-type heat pipe LH1 of the present embodiment, the heat dissipation plate 30 can be fixed on the condenser 13 by the attraction force of the magnet 60 and the magnetic film 50 without using a screw or an adhesive. For this reason, it is possible to favorably suppress deformation and distortion from being generated in the condenser 13, and to favorably suppress the thermal conductivity from the condenser 13 to the heat dissipation plate 30 from being lowered.
(3) The heat dissipation 30 is thermally connected to the condenser 13 of the loop-type heat pipe main body 10. According to this configuration, since the heat dissipation plate 30 can be thermally connected to the condenser 13 configured to dissipate heat generated by the heat-generating component 100, the heat generated by the heat-generating component 100 can be efficiently dissipated to the heat dissipation plate 30.
(4) The magnetic film 50 is a nickel plating film. The magnetic film 50 has a rust-preventing function of preventing rust on the surface of the loop-type heat pipe main body 10. For this reason, the magnetic film 50 consisting of a nickel plating film has both a rust-preventing function and a fixing function of the heat dissipation plate 30 by adsorption with the magnet 60. Therefore, the structure of the entire loop-type heat pipe LH1 can be simplified, as compared to a case in which the rust-preventing function and the fixing function are provided on separate members.
(5) The magnetic film 50 consisting of a nickel plating film is formed to cover the entire surface of the loop-type heat pipe main body 10. By the magnetic film 50, it is possible to favorably prevent rust on the entire surface of the loop-type heat pipe main body 10.
(6) The magnetic film 50 is a nickel plating film made of an alloy containing nickel and phosphorus, for example, a nickel-phosphorus alloy. According to this configuration, phosphorus is contained, so that the stiffness of the magnetic film 50 can be improved, as compared to a case in which phosphorus is not contained. Thereby, the stiffness of the entire loop-type heat pipe main body 10 covered by the magnetic film 50 can be improved. As a result, it is possible to suppress deformation such as bending from being generated in the loop-type heat pipe main body 10.
(7) The second facing surface 30A of the heat dissipation plate 30 is made to be in contact with the magnetic film 50 of a part that covers the first facing surface 13A of the condenser 13. According to this configuration, the first facing surface 13A and the second facing surface 30A are connected via the magnetic film 50, so that the condenser 13 and the heat dissipation plate 30 are thermally connected. In addition, a member with low thermal conductivity, such as an adhesive layer, is not interposed between the first facing surface 13A and the second facing surface 30A. For this reason, it is possible to favorably suppress the thermal conductivity from the condenser 13 to the heat dissipation plate 30 from being lowered.
(8) The magnet 60 is embedded in the heat dissipation plate 30. According to this configuration, it is possible to favorably suppress the size of the heat dissipation plate 30 from being increased in the Z-axis direction due to the magnet 60 provided.
(9) The magnet 60 is formed to penetrate through the heat dissipation plate 30 in the thickness direction of the heat dissipation plate 30 (in the direction in which the magnet 60 and the magnetic film 50 face to each other). According to this configuration, the thickness of the magnet 60 can be easily formed to be thick.

### (Other Embodiments)

The above embodiment can be changed and implemented, as follows. The above embodiment and the following modified embodiments can be implemented in combination with each other within a technically consistent range.

In the above embodiment, the magnetic film 50 of a part that covers the first facing surface 13A of the condenser 13 and the second facing surface 30A of the heat dissipation plate 30 are made to be in direct contact with each other. However, the present invention is not limited thereto.

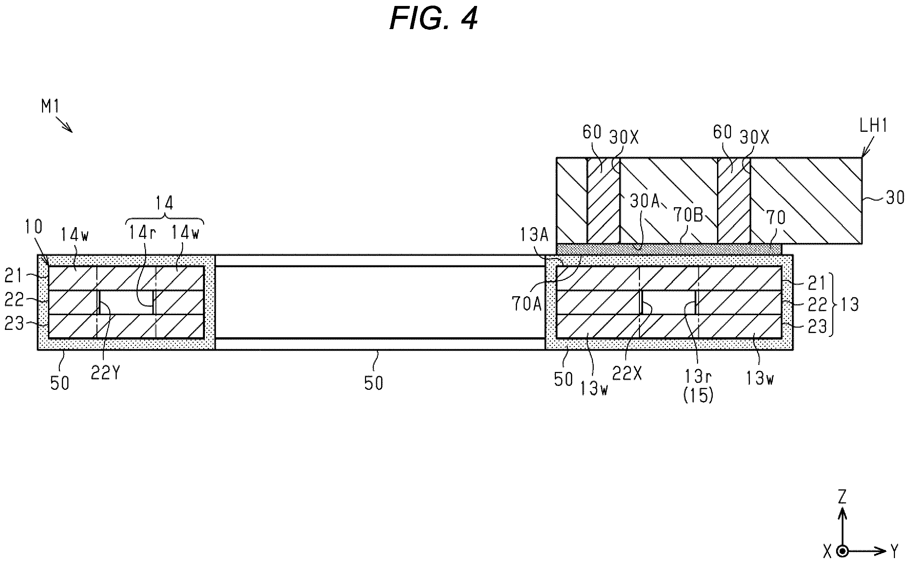

For example, as shown in FIG. 4, a heat conduction member 70 may be interposed between the magnetic film 50 and the second facing surface 30A. In this case, the heat dissipation plate 30 is thermally connected to the condenser 13 via the heat conduction member 70 and the magnetic film 50.

### Configuration of Heat Conduction Member 70

As a material of the heat conduction member 70, for example, a thermal interface material (TIM) can be used. As the material of the heat conduction member 70, for example, soft metal such as indium (In) and silver, silicone gel or an organic resin binder containing a metal filler, graphite, or the like can be used.

The heat conduction member 70 has a first end face 70A facing the first facing surface 13A of the condenser 13, and a second end face 70B facing the second facing surface 30A of the heat dissipation plate 30. The first end face 70A faces the magnetic film 50, for example. At least one of the first end face 70A and the second end face 70B of the heat conduction member 70 is formed as a non-adhesive surface, for example. In the heat conduction member 70 of the present modified embodiment, both the first end face 70A and the second end face 70B are formed as non-adhesive surfaces. For this reason, the first end face 70A of the heat conduction member 70 is not bonded to the upper surface of the magnetic film 50, and the second end face 70B of the heat conduction member 70 is not bonded to the second facing surface 30A of the heat dissipation plate 30. However, the first end face 70A of the heat conduction member 70 is in contact with the upper surface of the magnetic film 50 so as to be thermally connectable to the upper surface of the magnetic film 50. In addition, the second end face 70B of the heat conduction member 70 is in contact with the second facing surface 30A so as to be thermally connectable to the second facing surface 30A of the heat dissipation plate 30. Note that, a thickness of the heat conduction member 70 may be set to about 20 µm to 100 µm, for example.

The heat conduction member 70 is provided, for example, on a part of the second facing surface 30A. The heat conduction member 70 is provided to overlap an entire surface of the first facing surface 13A, in the top view, for example. The heat conduction member 70 is formed to cover an entire surface of the magnetic film 50 at a part that covers the first facing surface 13A, for example. The heat conduction member 70 is provided to overlap the magnet 60 in the top view, for example. The heat conduction member 70 is provided to overlap the flow path 13r in the top view, for example.

In the present modified embodiment, the magnet 60 and the magnetic film 50 are not in direct contact with each other. Even in this case, the heat dissipation plate 30 is fixed on the condenser 13 by the attraction force generated between the magnet 60 and the magnetic film 50. In other words, even when the magnet 50 and the magnetic film 60 are not in direct contact with each other, the type and thickness of the magnetic film 50 and the type, number, size, and the like of the magnet 60 are set so that the heat dissipation plate 30 can be fixed on the condenser 13.

In the present modified embodiment, the heat conduction member 70 is interposed between the magnetic film 50 that covers the first facing surface 13A of the condenser 13 and the second facing surface 30A of the heat dissipation plate 30. The heat conduction member 70 can reduce a contact thermal resistance between the magnetic film 50 and the second facing surface 30A, and can smoothly conduct heat from the condenser 13 to the heat dissipation plate 30. For this reason, the heat in the condenser 13 can be efficiently conducted to the heat dissipation plate 30 via the heat conduction member 70.

In addition, both the first end face 70A and the second end face 70B of the heat conduction member 70 are formed as non-adhesive surfaces. For this reason, it is possible to suppress interposition of an adhesive layer with low thermal conductivity between the condenser 13 and the heat dissipation plate 30. Therefore, it is possible to favorably suppress the thermal conductivity from the condenser 13 to the heat dissipation plate 30 from being lowered.

In the modified embodiment shown in FIG. 4, either the first end face 70A or the second end face 70B of the heat conduction member 70 may be used as an adhesive surface.

In the modified embodiment shown in FIG. 4, both the first end face 70A and the second end face 70B of the heat conduction member 70 may be used as adhesive surfaces.

In the modified embodiment shown in FIG. 4, the heat conduction member 70 is provided to overlap the entire surface of the first facing surface 13A of the condenser 13, in the top view. However, the present invention is not limited thereto.

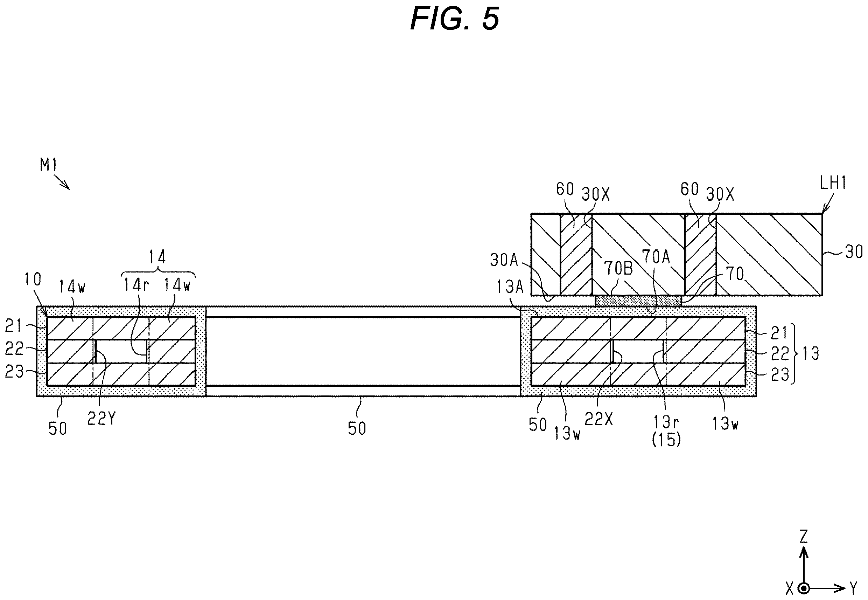

For example, as shown in FIG. 5, the heat conduction member 70 may be provided to overlap only a part of the first facing surface 13A in the top view. The heat conduction member 70 of the present modified embodiment is provided so as not to overlap the magnet 60 in the top view. The heat conduction member 70 of the present modified embodiment is provided to overlap the flow path 13r in the top view. Note that, in the present modified embodiment, an air layer is interposed between the magnet 60 and the magnetic film 50.

In the above embodiment, the magnet 60 is formed to penetrate through the heat dissipation plate 30 in the thickness direction. However, the present invention is not limited thereto.

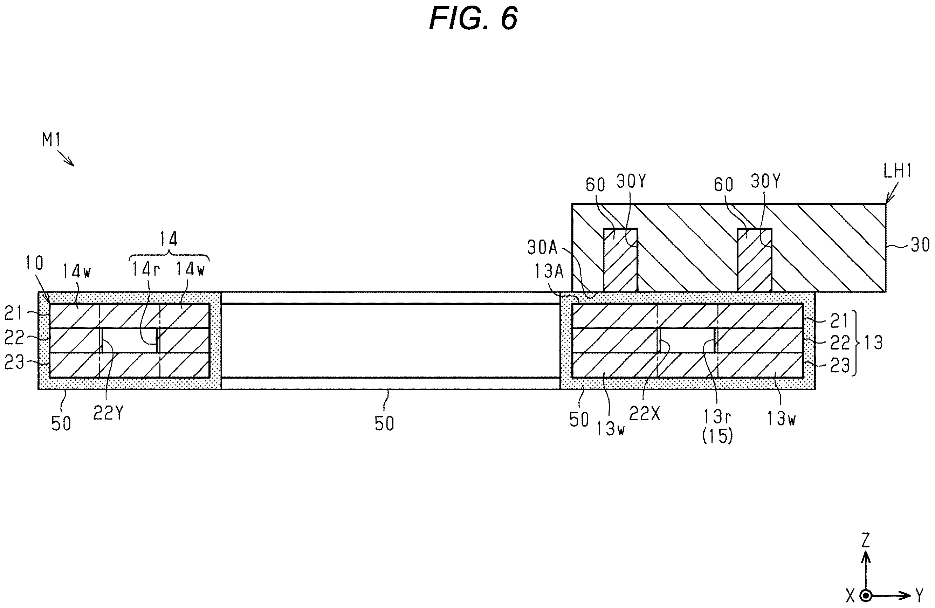

For example, as shown in FIG. 6, the magnet 60 may be formed so as not to penetrate through the heat dissipation plate 30 in the thickness direction. In this case, for example, the heat dissipation plate 30 is provided with a plurality of concave portions 30Y. Each concave portion 30Y is formed so as not to penetrate through the heat dissipation plate 30 in the thickness direction. Each concave portion 30Y is formed to be concave from the second facing surface 30A toward the upper surface of the heat dissipation plate 30, for example. A bottom surface of each concave portion 30Y is provided in the middle of the heat dissipation plate 30 in the thickness direction. Each of the magnets 60 is accommodated in each concave portion 30Y. The side surface of each of the magnets 60 is in close contact with an inner surface of each concave portion 30Y, for example. Note that, the side surface of each of the magnets 60 and the inner surface of each concave portion 30Y may be in direct contact with each other or may be in contact with each other via an adhesive member or the like.

A depth of the concave portion 30Y shown in FIG. 6 can be changed as appropriate.

The concave portion 30Y shown in FIG. 6 may be formed to be concave from the upper surface of the heat dissipation plate 30 toward the second facing surface 30A.

In the above embodiment, the lower surface of the magnet 60 is formed to be flush with the second facing surface 30A. However, the present invention is not limited thereto.

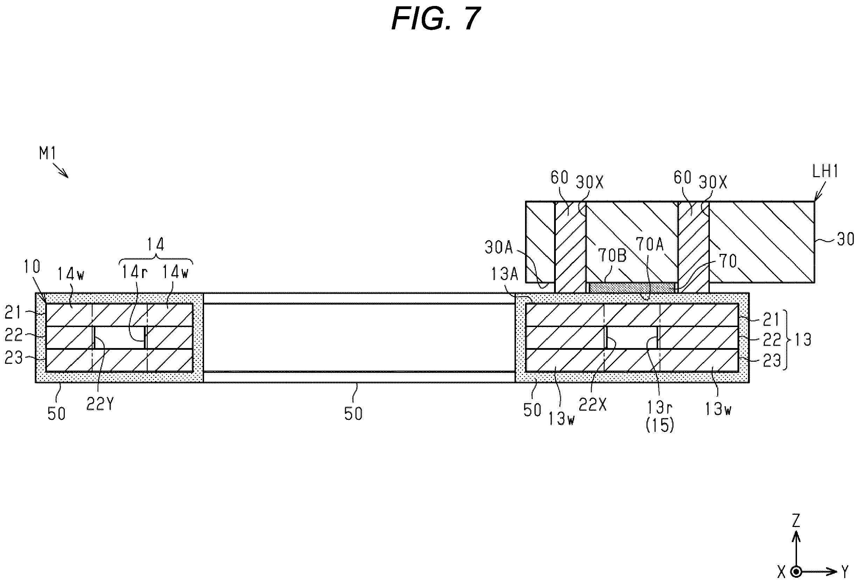

For example, as shown in FIG. 7, the magnet 60 may be formed to protrude toward the first facing surface 13A beyond the second facing surface 30A. In this case, the lower part of the magnet 60 protrudes downward beyond the second facing surface 30A. At this time, a protrusion amount of the magnet 60 from the second facing surface 30A is set to be equal to or smaller than the thickness of the heat conduction member 70. In addition, the magnet 60 of the present modified embodiment is provided so as not to overlap the heat conduction member 70 in the top view. Thereby, even when the magnet 60 protrudes beyond the second facing surface 30A, the condenser 13 and the heat dissipation plate 30 can be favorably thermally connected to each other via the heat conduction member 70.

In the above embodiment, the upper surface of the magnet 60 is formed to be flush with the upper surface of the heat dissipation plate 30. However, the present invention is not limited thereto. For example, the upper part of the magnet 60 may be formed to protrude upward beyond the upper surface of the heat dissipation plate 30. In addition, for example, the upper part of the magnet 60 may be formed to be located closer to the second facing surface 30A side than the upper surface of the heat dissipation plate 30.

In the above embodiment, the magnet 60 is provided embedded in the heat dissipation plate 30. However, the present invention is not limited thereto. For example, the magnet 60 may be provided on the outer surface of the heat dissipation plate 30.

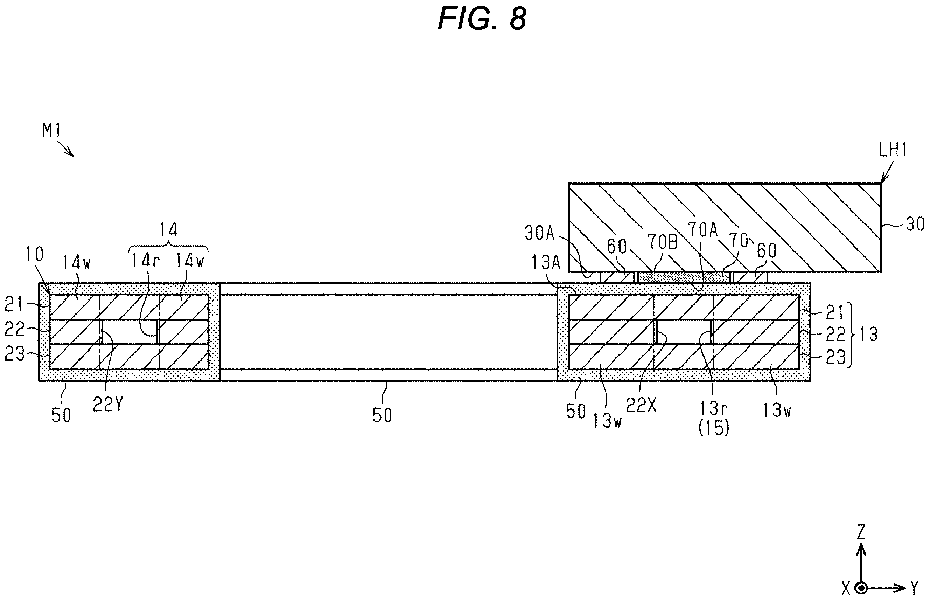

For example, as shown in FIG. 8, the magnet 60 may be provided on the second facing surface 30A of the heat dissipation plate 30. In this case, the thickness of the magnet 60 is set to be equal to or smaller than the thickness of the heat conduction member 70. In addition, the magnet 60 of the present modified embodiment is provided so as not to overlap the heat conduction member 70 in the top view. Thereby, even when the magnet 60 is provided on the second facing surface 30A, the condenser 13 and the heat dissipation plate 30 can be favorably thermally connected to each other via the heat conduction member 70.

In the above embodiment, the magnetic film 50 is formed by the electrolytic plating method or the electroless plating method. However, the present invention is not limited thereto. For example, the magnetic film 50 may be formed by a spin spray method or the like.

In the above embodiment, the magnetic film 50 is provided to cover the entire surface of the loop-type heat pipe main body 10. However, the present invention is not limited thereto.

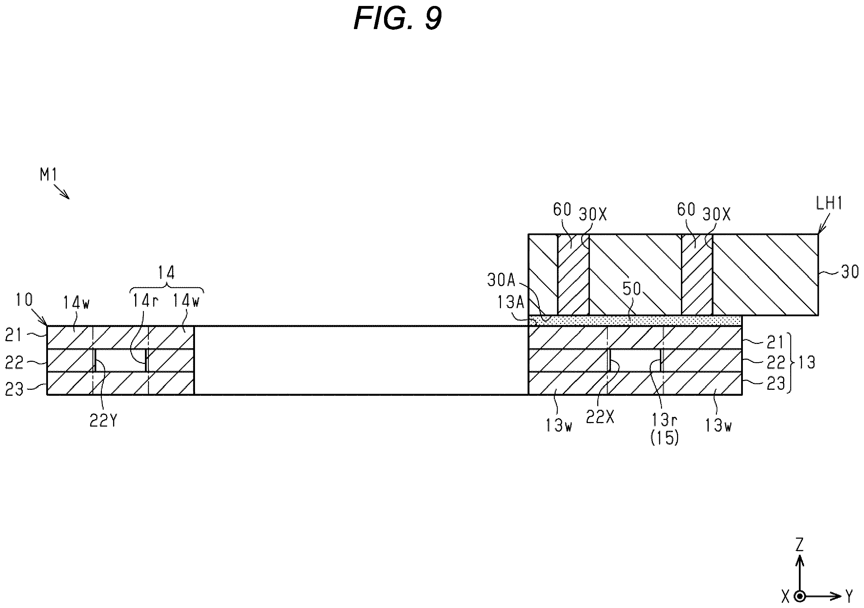

For example, as shown in FIG. 9, the magnetic film 50 may be provided to cover only the first facing surface 13A of the condenser 13. That is, the magnetic film 50 may be provided to cover only the first facing surface 13A of the surface of the loop-type heat pipe main body 10. In this case, parts of the surface of the loop-type heat pipe main body 10 other than the first facing surface 13A, for example, the side and lower surfaces of the condenser 13, the surface of the liquid pipe 14 and the like are exposed from the magnetic film 50.

In the above embodiment, the heat dissipation plate 30 is thermally connected to the condenser 13 of the loop-type heat pipe main body 10. However, the present invention is not limited thereto. For example, the heat dissipation plate 30 may be thermally connected to the liquid pipe 14. For example, the heat dissipation plate 30 may be thermally connected to the vapor pipe 14. For example, the heat dissipation plate 30 may be thermally connected to the entire loop-type heat pipe main body 10.

In the above embodiment, the loop-type heat pipe main body 10 is provided with the magnetic film 50 and the heat dissipation plate 30 is provided with the magnet 60. However, the present invention is not limited thereto.

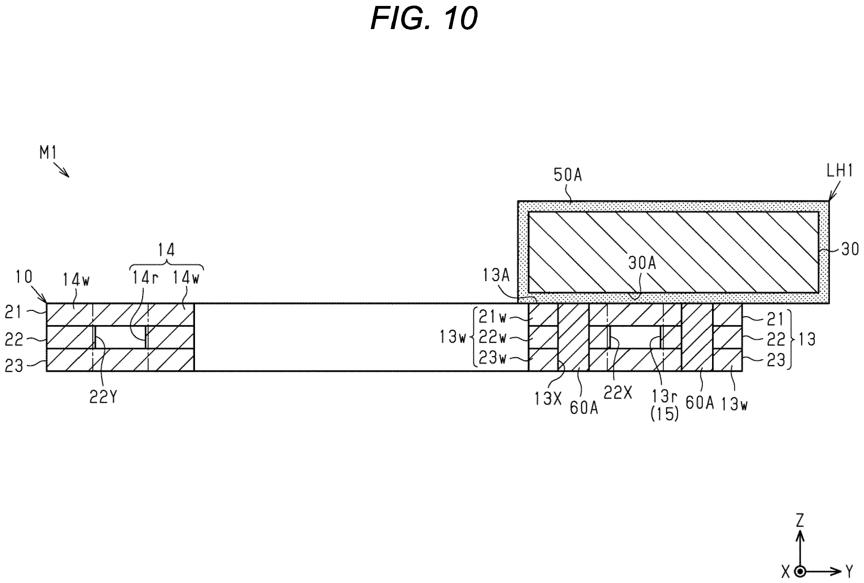

For example, as shown in FIG. 10, the heat dissipation plate 30 may be provided with a magnetic film 50A, and the loop-type heat pipe main body 10 may be provided with a magnet 60A. The magnetic film 50A is formed to cover the second facing surface 30A of the surface of the heat dissipation plate 30. The magnetic film 50A of the present modified embodiment is formed to cover the entire surface of the heat dissipation plate 30. Note that, as a material of the magnetic film 50A, for example, a material similar to that of the magnetic film 50 shown in FIG. 1 may be used.

### (Configuration of Magnet 60A)

The heat magnet 60A is provided in the condenser 13 of the loop-type heat pipe main body 10, for example. The condenser 13 of the present modified embodiment is provided with a plurality of magnets 60A. Each of the magnets 60A is embedded in the condenser 13, for example. Each of the magnets 60A is embedded in the pipe wall 13w of the condenser 13, for example. Each of the magnets 60A is provided so as not to overlap the flow path 15, specifically, the flow path 13r, in the top view, for example.

Each of the magnets 60A is provided to penetrate through the pipe wall 13w in the thickness direction (here, Z-axis direction). For example, the pipe wall 13w is provided with a plurality of through-holes 13X penetrating through the pipe wall 13w in the thickness direction. Each of the magnets 60A is accommodated in each through-hole 13X, for example. A side surface of each of the magnets 60A is in close contact with an inner surface of each through-hole 13X, for example. The side surface of each of the magnets 60A is in close contact with the inner surface of each through-hole 13X over an entire circumference of the magnet 60A in a circumferential direction, for example. Note that, the side surface of each of the magnets 60A and the inner surface of each through-hole 13X may be in direct contact with each other or may be in contact with each other via an adhesive member or the like. An upper surface of each of the magnets 60A is exposed from, for example, the upper surface of the metal layer 21, i.e., the first facing surface 13A. The upper surface of each of the magnets 60A is formed flush with the first facing surface 13A, for example. A lower surface of each of the magnets 60A is exposed from the lower surface of the metal layer 23, for example. The lower surface of each of the magnets 60A is formed flush with the lower surface of the metal layer 23, for example. Note that, as the magnet 60A, for example, a magnet of the same type as the magnet 60 shown in FIG. 1 may be used.

In this configuration, when the magnet 60A and the magnetic film 50 come close to each other, a magnetic attraction force (adsorption force) with which the magnet 60A and the magnetic film 50A try to adsorb to each other is generated between the magnet 60A and the magnetic film 50A. By the magnetic attraction force, the magnet 60A and the magnetic film 50A are adsorbed to each other. Thereby, the heat dissipation plate 30 is fixed on the condenser 13 of the loop-type heat pipe main body 10 via the magnetic film 50A. That is, the heat dissipation plate 30 is fixed on the condenser 13 by the attraction force (adsorption force) generated between the magnet 60A and the magnetic film 50A. In other words, the type and thickness of the magnetic film 50A and the type, number, size, and the like of the magnet 60A are set so that the heat dissipation plate 30 can be fixed on the condenser 13. Here, in the loop-type heat pipe LH1 of the present modified embodiment, the first facing surface 13A of the condenser 13 and the second facing surface 30A of the heat dissipation plate 30 are connected via the magnetic film 50A, so that the condenser 13 and the heat dissipation plate 30 are thermally connected to each other. Thereby, a path through which heat is conducted from the condenser 13 to the heat dissipation plate 30 via the magnetic film 50A is formed. Therefore, the heat in the condenser 13 can be efficiently dissipated by the heat dissipation plate 30.

The planar shape of the magnet 60 in the above embodiment is not particularly limited. For example, the planar shape of the magnet 60 may be formed in an arbitrary shape such as a polygonal shape, a semicircular shape or an elliptical shape.

The shape of the flow path 13r in the condenser 13 in the above embodiment is not particularly limited.

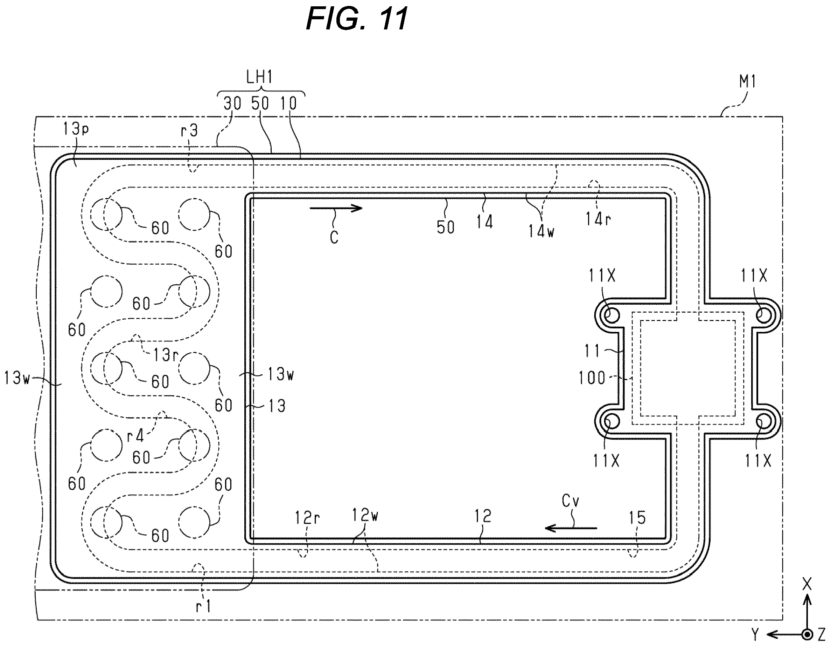

For example, as shown in FIG. 11, the flow path 13r may be formed in a shape having a serpentine part r4 meandering in an XY plane. The flow path 13r of the present modified embodiment includes a flow path r1 extending in the Y-axis direction, a serpentine part r4 extending in the X-axis direction while meandering from an end portion of the flow path r1, and a flow path r3 extending in the Y-axis direction from an end portion of the serpentine part r4. The magnet 60 in the present modified embodiment may be provided at a position overlapping the flow path 13r or may be provided at a position where it does not overlap the flow path 13r, in the top view, for example.

In the above embodiment, the plurality of magnets 60 may be formed in different shapes from each other.

In the loop-type heat pipe main body 10 of the above embodiment, the inner metal layer is configured only by the metal layer 22 of a single layer. That is, the inner metal layer is formed to have a single layer structure. However, the present invention is not limited thereto. For example, the inner metal layer may also be formed to have a stacked structure where a plurality of metal layers is stacked. In this case, the inner metal layer is configured by a plurality of metal layers stacked between the metal layer 21 and the metal layer 23.

In the above embodiment, the magnetic film 50 is used as one example of the magnetic member. However, the present invention is not limited thereto. For example, a magnetic plate such as an iron plate can be used as the magnetic member.

## Claims

1. A loop-type heat pipe (LH1) comprising:
a loop-type heat pipe main body (10) including a loop-shaped flow path (15) in which a working fluid is enclosed;
a heat dissipation plate (30) thermally connected to the loop-type heat pipe main body (10);
a magnetic member (50) provided on a surface of one of the loop-type heat pipe main body (10) and the heat dissipation plate (30); and
a magnet (60) provided for the other of the loop-type heat pipe main body (10) and the heat dissipation plate (30) and provided facing the magnetic member (50).

2. The loop-type heat pipe according to Claim 1, wherein the magnetic member (50) is provided on a surface of the loop-type heat pipe main body (10), and
wherein the magnet (60) is provided for the heat dissipation plate (30).

3. The loop-type heat pipe according to Claim 2, wherein the loop-type heat pipe main body (10) comprises:
an evaporator (11) configured to vaporize the working fluid,
a condenser (13) configured to condense the working fluid,
a liquid pipe (14) configured to connect the evaporator (11) and the condenser (13) to each other, and
a vapor pipe (12) configured to connect the evaporator (11) and the condenser (13) to each other,
wherein the magnetic member (50) is formed to cover a surface of the condenser (13), and
wherein the heat dissipation plate (30) is thermally connected to the condenser (13).

4. The loop-type heat pipe according to Claim 3, wherein the magnetic member (50) is a plating film of a metal including nickel.

5. The loop-type heat pipe according to Claim 4, wherein the magnetic member (50) is formed to cover an entire surface of the loop-type heat pipe main body (10).

6. The loop-type heat pipe according to any one of Claims 3 to 5, wherein the condenser (13) has a first facing surface (13A) facing the heat dissipation plate (30),
wherein the heat dissipation plate (30) has a second facing surface (30A) facing the first facing surface (13A),
wherein the magnetic member (50) is formed to cover the first facing surface (13A), and
wherein the second facing surface (30A) is in contact with the magnetic member (50).

7. The loop-type heat pipe according to any one of Claims 3 to 5, further comprising:
a heat conduction member (70),
wherein the condenser (13) has a first facing surface (13A) facing the heat dissipation plate (30),
wherein the heat dissipation plate (30) has a second facing surface (30A) facing the first facing surface (13A),
wherein the magnetic member (50) is formed to cover the first facing surface (13A),
wherein the heat conduction member (70) is provided between the second facing surface (30A) and the magnetic member (50), and
wherein the heat dissipation plate (30) is thermally connected to the condenser via the heat conduction member (70) and the magnetic member (50).

8. The loop-type heat pipe according to Claim 7, wherein the heat conduction member (70) has a first end face (70A) and a second end face (70B) in a thickness direction of the heat conduction member (70),
wherein the first end face (70A) faces the first facing surface (13A),
wherein the second end face (70B) faces the second facing surface (30A), and
wherein at least one of the first end face (70A) and the second end face (70B) is a non-adhesive surface.

9. The loop-type heat pipe according to Claim 7 or 8, wherein the magnet (60) is provided to protrude toward the first facing surface (13A) beyond the second facing surface (30A), and
wherein a protrusion amount of the magnet (60) from the second facing surface (30A) is equal to or smaller than a thickness of the heat conduction member (70).

10. The loop-type heat pipe according to any one of Claims 2 to 9, wherein the magnet (60) is embedded in the heat dissipation plate (30), and
wherein the magnet (60) penetrates through the heat dissipation plate (30) in a direction in which the magnet (60) and the magnetic member (50) face to each other.
